# EUROPEAN PATENT SPECIFICATION

(11) **EP 3 484 901 B1**
(45) Date of publication and mention of the grant of the patent: **15.06.2022**
(21) Application number: 17739588.6
(22) Date of filing: 14.07.2017
(51) Int. Cl.: C07F 15/04, C07F 15/06, C23C 16/455

(54) **HAPTO-3-PENTADIENYL COBALT OR NICKEL PRECURSORS AND THEIR USE IN THIN FILM DEPOSITION PROCESSES**
HAPTO-3-PENTADIENYLKOBALT ODER -NICKELVORLÄUFERVERBINDUNGEN UND DEREN VERWENDUNG IN DÜNNFILMABSCHEIDUNGSPROZESSEN
COMPOSÉS PRÉCURSEURS DE HAPTO-3-PENTADIENYL COBALT OU NICKEL ET LEUR UTILISATION DANS DES PROCÉDÉS POUR LA PRODUCTION DE FILMS MINCES

(30) Priority: 18.07.2016 EP 16179948
(43) Date of publication of application: 22.05.2019
(73) Proprietor: BASF SE, 67056 Ludwigshafen am Rhein (DE)
(72) Inventor: LIMBURG, Carolin, 67056 ludwigshafen (DE); LOEFFLER, Daniel, 67056 Ludwigshafen (DE); WILMER, Hagen, 67056 Ludwigshafen (DE); WALTER, Marc, 38106 Braunschweig (DE); REINERS, Matthias, 38106 Braunschweig (DE)
(74) Representative: BASF IP Association
(86) International application number: PCT/EP2017/067888
(87) International publication number: WO 2018/015305

(56) References cited:
- C. Krüger: "Crystal Structure of Bis(pentadienyl)dinickel", Angew. Chem. internat. Edit., vol. 8, no. 9 1969, pages 678-678, XP055343730, Retrieved from the Internet: URL:http://onlinelibrary.wiley.com/store/1 0.1002/anie.196906781/asset/196906781_ftp. pdf?v=1&t=iyx3dhqi&s=ad2d772b1cbf772a96afe 52422cdb2ba3c41fc99 [retrieved on 2017-02-08]
- DAVID R. WILSON ET AL: "Open cobaltocene chemistry. The dimerization of bis(2,4-dimethylpentadienyl)cobalt", ORGANOMETALLICS, vol. 3, no. 9, 1 September 1984 (1984-09-01), pages 1442-1444, XP055344031, US ISSN: 0276-7333, DOI: 10.1021/om00087a024
- GENE-HSIANG LEE ET AL: "Synthesis, characterization and crystal structure of dicarbonyl(syn-[eta]3-2,4-pentadienyl)trip henylphosphinecobalt", JOURNAL OF ORGANOMETALLIC CHEMISTRY, vol. 312, 1 January 1986 (1986-01-01), pages 113-120, XP055343795,
- John R Bleeke ET AL: "Synthesis, Structure, and Solution Dynamics of ( q5-2,4-Dlmethylpentadienyl)Co[ P(C2H5)3]2 and ( anfi-q3-2,4-Dimethylpentadienyl)Co[ P( CH3),I3", Organometallics, 1 January 1984 (1984-01-01), pages 1422-1426, XP055343802, Retrieved from the Internet: URL:http://pubs.acs.org/doi/pdf/10.1021/om 00087a019 [retrieved on 2017-02-08]

## Description

The present invention is in the field of processes for the generation of thin inorganic films on substrates, in particular atomic layer deposition processes.

With the ongoing miniaturization, e.g. in the semiconductor industry, the need for thin inorganic films on substrates increases while the requirements of the quality of such films become stricter. Thin inorganic films serve different purposes such as barrier layers, dielectrica, conducting features, capping, or separation of fine structures. Several methods for the generation of thin inorganic films are known. One of them is the deposition of film forming compounds from the gaseous state on a substrate. In order to bring metal atoms into the gaseous state at moderate temperatures, it is necessary to provide volatile precursors, e.g. by complexation the metals with suitable ligands. These ligands need to be removed after deposition of the complexed metals onto the substrate.

Metal complexes for gas phase deposition are known from prior art. WO 2008 / 142 653 discloses hexadienyl cobalt complexes with π-donating ligands, such as cyclopentadienyl. However, films obtained with such compounds contain a considerable amount of residual carbon which is undesirable in many cases.

C. Krüger discloses in Angewandte Chemie International Edition, volume 8 (1969), page 678 the crystal structure of bis(pentadienyl)dinickel. No indication for its suitability in gas phase deposition nor any structural derivatives of this one compound are given.

D. Wilson et at. disclose in Organometallics, 1984, page 1442-1444 the dimerization of bis(2,4-dimethylpentadienyl)cobalt. No indication for its suitability in gas phase deposition nor any structural derivatives of this one compound are given.

G. Lee et al. disclose in the Journal of Organometallic Chemistry, volume 312 (1986), pages 113-120 the synthesis, characterization and crystal structure of dicarbonyl(syn- *η*³-2,4-pentadienyl)triphenylphosphinecobalt. No indication for its suitability in gas phase deposition nor any structural derivatives of this one compound are given.

J. Bleek et al. disclose in Organometallics 1984, page 1422-1426 synthesis, structure, and solution dynamics of (*η*⁵-2,4-dimethylpentadienyl)Co[P(C₂H₅)₃]₂ and (anti-*η*³-2,4-dimethylpentadienyl)Co[P(CH₃)₃]₃. No indication for its suitability in gas phase deposition nor any structural derivatives of this one compound are given.

It was an object of the present invention to provide a process for the generation of thin inorganic films with lower residual carbon content. Furthermore, it was aimed at a process employing compounds which can be synthesized and handled more easily. The process should also be flexible with regard to parameters such as temperature or pressure in order to be adaptable to various different applications.

These objects were achieved by a process comprising bringing a compound of general formula (I) into the gaseous or aerosol state 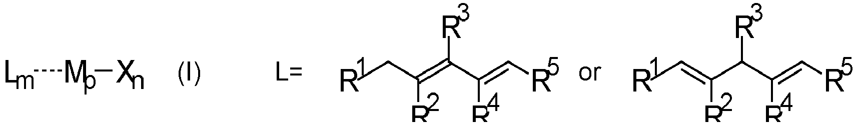 and depositing the compound of general formula (I) from the gaseous or aerosol state onto a solid substrate, wherein
R¹, R², R³, R⁴, and R⁵ are independent of each other hydrogen, an alkyl group, an alkenyl group, an aryl group or a silyl group,
p is 1 or 2,
M is Ni or Co,
X is a σ-donating ligand which coordinates M,
m is 1 or 2 and
n is 0 to 3.

The present invention further relates to a compound of general formula (I), wherein
R¹, R², R³, R⁴, and R⁵ are independent of each other hydrogen, an alkyl group, an alkenyl group, an aryl group or a silyl group,
p is 1 or 2
M is Ni or Co,
X is a σ-donating ligand which coordinates M, wherein at least one X coordinates M via a phosphor atom and contains two or more phosphor atoms,
m is 1 or 2 and
n is 1 to 3.

The present invention further relates to use of a compound of general formula (I) according to the present invention for a film formation process.

A method of deposition of a compound of general formula (I) on a solid substrate, a compound of formula (I) and the use of such compound for a film formation process according to the invention are defined in the appended claims.

Preferred embodiments of the present invention can be found in the description and the claims.

Combinations of different embodiments fall within the scope of the present invention.

The ligands L is an anionic ligand which typically means that the ligand is an anion before coordinating to M. Sometimes, the delocalization of the charge is reflected in the formula, which then becomes general formula (I').

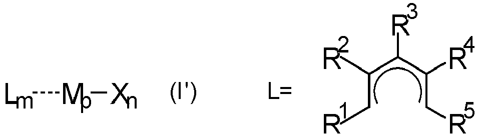

However, neither general formula (I) nor (I') is intended to define how the ligand L coordinates to M. It is, for example, possible that L coordinates via a η¹, a η³ or a η⁵ bond to M. Without being bound by any theory, it is believed that the other ligand or ligands X have an influence on how L is coordinated to M.

The ligand L is capable of coordinating one or two metals M. Therefore, p can be 1 or 2. If p is 2, the two M can be the same or different to each other, preferably they are the same. If p is 1, general formula (I) can be written as general formula (Ia) and if p is 2 general formula (I) can be written as general formula (lb).

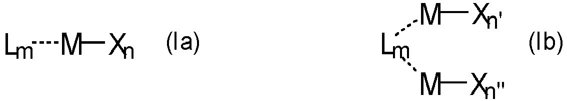

The indices n' and n" are such that the equation n' + n" = n is satisfied. Preferably n' and n" are the same, more preferably n' and n" are 0. In this case, m is often 2, so that the compound of general formula (I) preferably becomes a compound of general formula (Ic).

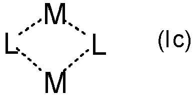

In the compound of general formula (I) R¹, R², R³, R⁴, and R⁵ are independent of each other hydrogen, an alkyl group, an alkylen group, an aryl group or a silyl group, preferably hydrogen, an alkyl or silyl group, in particular hydrogen. It is possible that all R¹, R², R³, R⁴, and R⁵ are the same, or that some of R¹, R², R³, R⁴, and R⁵ are the same and the remaining are different therefrom or that all R¹, R², R³, R⁴, and R⁵ are different to each other. Preferably R² and R⁴ are alkyl and R¹, R³, and R⁵ are hydrogen.

An alkyl group can be linear or branched. Examples for a linear alkyl group are methyl, ethyl, n-propyl, n-butyl, n-pentyl, n-hexyl, n-heptyl, n-octyl, n-nonyl, n-decyl. Examples for a branched alkyl group are iso-propyl, iso-butyl, sec-butyl, tert-butyl, 2-methyl-pentyl, 2-ethyl-hexyl, cyclopropyl, cyclohexyl, indanyl, norbornyl. Preferably, the alkyl group is a C₁ to C₈ alkyl group, more preferably a C₁ to C₆ alkyl group, in particular a C₁ to C₄ alkyl group, such as methyl, ethyl, iso-propyl or tert-butyl. Alkyl groups can be substituted, for example by halogens such as F, Cl, Br, I, in particular F; by hydroxyl groups; by ether groups; or by amines such as dialkylamines.

An alkenyl group contains at least one carbon-carbon double bond. The double bond can include the carbon atom with which the alkenyl group is bound to the rest of the molecule, or it can be placed further away from the place where the alkenyl group is bound to the rest of the molecule, preferably it is placed further away from the place where the alkenyl group is bound to the rest of the molecule. Alkenyl groups can be linear or branched. Examples for linear alkenyl groups in which the double bond includes the carbon atom with which the alkenyl group is bound to the rest of the molecule include 1-ethenyl, 1-propenyl, 1-n-butenyl, 1-n-pentenyl, 1-n-hexenyl, 1-n-heptenyl, 1-n-octenyl. Examples for linear alkenyl groups in which the double bond is placed further away from the place where alkenyl group is bound to the rest of the molecule include 1-n-propen-3-yl, 2-buten-1-yl, 1-buten-3-yl, 1-buten-4-yl, 1-hexen-6-yl. Examples for branched alkenyl groups in which the double bond includes the carbon atom with which alkenyl group is bound to the rest of the molecule include 1-propen-2-yl, 1-n-buten-2-yl, 2-buten-2-yl, cyclopenten-1-yl, cyclohexen-1-yl. Examples for branched alkenyl groups in which the double bond is placed further away from the place where alkenyl group is bound to the rest of the molecule include 2-methyl-1-buten-4-yl, cyclopenten-3-yl, cyclohexene-3-yl. Examples for an alkenyl group with more than one double bonds include 1,3-butadien-1-yl, 1,3-butadien-2-yl, cylopentadien-5-yl.

Aryl groups include aromatic hydrocarbons such as phenyl, naphthalyl, anthrancenyl, phenanthrenyl groups and heteroaromatic groups such as pyrryl, furanyl, thienyl, pyridinyl, quinoyl, benzofuryl, benzothiophenyl, thienothienyl. Several of these groups or combinations of these groups are also possible like biphenyl, thienophenyl or furanylthienyl. Aryl groups can be substituted for example by halogens like fluoride, chloride, bromide, iodide; by pseudohalogens like cyanide, cyanate, thiocyanate; by alcohols; alkyl chains or alkoxy chains. Aromatic hydrocarbons are preferred, phenyl is more preferred.

A silyl group is a silicon atom with typically three substituents. Preferably a silyl group has the formula SiE₃, wherein E is independent of each other hydrogen, an alkyl group, an alkenyl group, an aryl group or a silyl group. It is possible that all three E are the same or that two E are the same and the remaining E is different or that all three E are different to each other. It is also possible that two E together form a ring including the Si atom. Alkyl and aryl groups are as described above. Examples for silyl groups include SiH₃, methylsilyl, trimethylsilyl, triethylsilyl, tri-n-propylsilyl, tri-iso-propylsilyl, tricyclohexylsilyl, dimethyl-tert-butylsilyl, dimethylcyclohexylsilyl, methyl-di-iso-propylsilyl, triphenylsilyl, phenylsilyl, dimethylphenylsilyl, pentamethyldisilyl.

According to the present invention, M is Ni or Co, i.e. nickel or cobalt. M can be in various oxidation states. Preferably, M is in the oxidation state +1 or +2.

According to the present invention, the ligand X in the compound of general formula (I) can be any σ-donating ligand which coordinates M. In the context of the present invention, any ligand which forms a σ-bond to M thereby providing an electron pair to M is regarded as σ-donating ligand irrespective of whether any further bond can be formed to M or is actually formed. If n is 2 or 3, i.e. the compound of general formula (I) contains two or three X, the two or three X can be the same or different to each other. Any or all X can be in any ligand sphere of M, e.g. in the inner ligand sphere, in the outer ligand sphere, or only loosely associated to M. Preferably, X is in the inner ligand sphere of M.

The ligand X in the compound of general formula (I) according to the present invention can be neutral or anionic. Examples for anionic ligands X include halogens like fluoride, chloride, bromide or iodide; pseudohalogens like cyanide, isocyanide, cyanate, isocyanate, thiocyanate, isothiocyanate, or azide; alkyl anions like methyl, ethyl, butyl, or neopentyl anions as well as silicon bearing alkyl groups such as trimethylsilyl methyl; hydride; alkanolates like methanolate, ethanolate, iso-propanolate, tert-butanolate; acetylacetonate or its derivatives such as 1,1,1,5,5,5-pentafluoroacetylacetonate; amine anions like dimethylamide, hexamethyldisilazide, or trimethylsilyl tert.-butyl amide.

Examples for neutral ligands X include nitric oxide (NO); carbonmonoxide (CO). Also, X can be a ligand which coordinates M via a nitrogen atom, for example amines like dimethylamine, trimethylamine, di-tertbutylamine, diphenylamine, dimethylamino-iso-propanol, bistrimethylsilylamine; ethylenediamine derivatives like N,N,N',N'-tetramethylethylenediamine or N,N,N',N",N"-pentamethyldiethylenetriamine; imines like 2,4-pentandione-N-alkylimines, 2,4-pentandione-N-iso-propylimine, glyoxal-N,N'-bis-isopropyl-diimine, glyoxal-N,N'-bis-tert-butyl-diimine or 2,4-pentanedione-diimine; diketiminates such as N,N'-2,4-pentanediketiminate; iminopyrroles including pyrrol-2-carbald-alkylimines such as pyrrol-2-carbald-ethylimine, pyrrol-2-carbald-isopropylimine or pyrrol-2-carbald-tert-butylimine as well as pyrrol-2,5-biscarbald-alkyldiimines such as pyrrol-2,5-biscarbald-tert-butyldiimine; amidinates such as acetamidine or N,N'-bis-isopropylacetamidine; guanidinates such as guanidine; aminoimines such as 2-N-tert-butylamino-2-methylpropanal-N-tertbuylimine; amides such as formamide or acetamide.

It is also possible that X is a ligand which coordinates M via a phosphor atom including phosphane or trisubstituted phosphanes including trihalogenphosphanes, trialkylphosphanes, dialkylarylphosphanes, alkyl-diarylphosphanes or triarylphosphanes, wherein the alkyl or the aryl groups can be the same or different to each other if more than one alkyl or aryl group is present. Examples include trifluoro phosphane, trimethyl phosphane, trimethoxyphosphane, methyl-dimethoxy phosphane, tri-tertbutyl phosphane, tricyclohexyl phosphane, di-isopropyl-tert-butyl phosphane, dimethyl-tert-butyl phosphane, triphenyl phosphane, and tritolylphosphane. It is also possible that X which coordinates via a phosphor atom contains two or more phosphor atoms. Such compounds include diphosphinoethanes such as 1,2-bis(dimethylphosphino)ethane or 1,2-bis(diethylphosphino)ethane.

Preferably, at least one X is CO or a ligand which coordinates M via a phosphor or nitrogen atom, in particular a trialkylphophane.

Preferably, in the compound of general formula (I), M is Co in the oxidation state +1, m is 1, and all X are neutral σ-donating ligands. In this case it is possible that the compound of general formula (I) contains one neutral ligands X, i.e. n is 1, or two or three, preferably two. Also preferably, M is Ni in the oxidation state +2, m is 2, and n is 0. Also preferably, M is Ni in the oxidation state +2, m is 1, and at least one X is an anionic σ-donating ligand, more preferably one X is anionic and the remaining X, if any, are neutral. For example, M is Ni in the oxidation state +2, m is 1, n is 2, wherein one X is anionic and one is neutral.

It is preferred that the molecular weight of the compound of general formula (I) is up to 1000 g/mol, more preferred up to 800 g/mol, in particular up to 600 g/mol. Some preferred examples for compounds of general formula (I) are given in the following table.

| No. | R¹ | R2 | R3 | R4 | R5 | p | m | M | X | n |
|---|---|---|---|---|---|---|---|---|---|---|
| C-1 | H | C(CH₃)₃ | H | C(CH₃)₃ | H | 1 | 2 | Ni | - | 0 |
| C-2 | H | C(CH₃)₃ | H | C(CH₃)₃ | H | 1 | 2 | Co | - | 0 |
| C-3 | H | C(CH₃)₃ | H | CH₃ | H | 1 | 2 | Ni | - | 0 |
| C-4 | H | C(CH₃)₃ | H | CH₃ | H | 2 | 2 | Ni | - | 0 |
| C-5 | H | C(CH₃)₃ | H | CH₃ | H | 1 | 2 | Co | - | 0 |
| C-6 | H | CH₃ | H | CH₃ | H | 1 | 2 | Ni | - | 0 |
| C-7 | H | CH₃ | H | CH₃ | H | 1 | 2 | Co | - | 0 |
| C-8 | H | C(CH₃)₃ | H | C(CH₃)₃ | H | 1 | 1 | Ni | N(CHMe₂)₂ Cl | 2 |
| C-9 | H | C(CH₃)₃ | H | C(CH₃)₃ | H | 1 | 1 | Ni | N(CMe₃)₂ | 2 |
| C-10 | H | C(CH₃)₃ | H | C(CH₃)₃ | H | 1 | 1 | Ni | N(C₆H₅)₂ Cl | 2 |
| C-11 | H | C(CH₃)₃ | H | C(CH₃)₃ | H | 1 | 1 | Ni | N(SiMe₃)₂ Cl | 2 |
| C-12 | H | C(CH₃)₃ | H | C(CH₃)₃ | H | 1 | 1 | Ni | PMe₃ Cl | 2 |
| C-13 | H | C(CH₃)₃ | H | C(CH₃)₃ | H | 1 | 1 | Ni | acac | 1 |
| C-14 | H | C(CH₃)₃ | H | CH₃ | H | 1 | 1 | Ni | N(CHMe₂)₂ Cl | 2 |
| C-15 | H | C(CH₃)₃ | H | CH₃ | H | 1 | 1 | Ni | N(CMe₃)₂ | 2 |
| C-16 | H | C(CH₃)₃ | H | CH₃ | H | 1 | 1 | Ni | N(C₆H₅)₂ Cl | 2 |
| C-17 | H | C(CH₃)₃ | H | CH₃ | H | 1 | 1 | Ni | N(SiMe₃)₂ Cl | 2 |
| C-18 | H | C(CH₃)₃ | H | CH₃ | H | 1 | 1 | Ni | P^{t}Bu₃ Cl | 2 |
| C-19 | H | C(CH₃)₃ | H | CH₃ | H | 1 | 1 | Ni | acac | 1 |
| C-20 | H | CH₃ | H | CH₃ | H | 1 | 1 | Ni | N(CHMe₂)₂ Cl | 2 |
| C-21 | H | CH₃ | H | CH₃ | H | 1 | 1 | Ni | N(CMe₃)₂ Cl | 2 |
| C-22 | H | CH₃ | H | CH₃ | H | 1 | 1 | Ni | N(C₆H₅)₂ Cl | 2 |
| C-23 | H | CH₃ | H | CH₃ | H | 1 | 1 | Ni | N(SiMe₃)₂ Cl | 2 |
| C-24 | H | CH₃ | H | CH₃ | H | 1 | 1 | Ni | P^{t}Bu₃ Cl | 2 |
| C-25 | H | CH₃ | H | CH₃ | H | 1 | 1 | Ni | acac | 1 |
| C-26 | H | C(CH₃)₃ | H | C(CH₃)₃ | H | 1 | 1 | Co | PMe₃ Cl | 2 |
| C-27 | H | C(CH₃)₃ | H | C(CH₃)₃ | H | 1 | 1 | Co | PMe₃ Cl | 3 |
| C-28 | H | C(CH₃)₃ | H | C(CH₃)₃ | H | 1 | 1 | Co | PF₃ | 2 |
| C-29 | H | C(CH₃)₃ | H | C(CH₃)₃ | H | 1 | 1 | Co | PF₃ | 3 |
| C-30 | H | C(CH₃)₃ | H | C(CH₃)₃ | H | 1 | 1 | Co | PMe₃ Cl CO | 2 |
| C-31 | H | C(CH₃)₃ | H | C(CH₃)₃ | H | 1 | 1 | Co | PMe₃ Cl CO CO | 3 |
| C-32 | H | C(CH₃)₃ | H | C(CH₃)₃ | H | 1 | 1 | Co | PMe₃ Cl PMe₃ Cl CO | 3 |
| C-33 | H | C(CH₃)₃ | H | C(CH₃)₃ | H | 1 | 1 | Co | PEt₃ | 2 |
| C-32 | H | C(CH₃)₃ | H | C(CH₃)₃ | H | 1 | 1 | Co | PEt₃ | 3 |
| C-33 | H | C(CH₃)₃ | H | C(CH₃)₃ | H | 1 | 1 | Co | depe | 1 |
| C-34 | H | C(CH₃)₃ | H | C(CH₃)₃ | H | 1 | 1 | Co | depe PMe₃ Cl | 2 |
| C-35 | H | C(CH₃)₃ | H | C(CH₃)₃ | H | 1 | 1 | Co | depe CO | 2 |
| C-36 | H | C(CH₃)₃ | H | C(CH₃)₃ | H | 1 | 1 | Co | CO | 2 |
| C-37 | H | C(CH₃)₃ | H | C(CH₃)₃ | H | 1 | 1 | Co | CO | 3 |
| C-38 | H | C(CH₃)₃ | H | C(CH₃)₃ | H | 1 | 1 | Co | tmeda | 1 |
| C-39 | H | C(CH₃)₃ | H | CH₃ | H | 1 | 1 | Co | PMe₃ Cl | 2 |
| C-40 | H | C(CH₃)₃ | H | CH₃ | H | 1 | 1 | Co | PMe₃ Cl | 3 |
| C-41 | H | C(CH₃)₃ | H | CH₃ | H | 1 | 1 | Co | PF₃ | 2 |
| C-42 | H | C(CH₃)₃ | H | CH₃ | H | 1 | 1 | Co | PF₃ | 3 |
| C-43 | H | C(CH₃)₃ | H | CH₃ | H | 1 | 1 | Co | PMe₃ Cl CO | 2 |
| C-44 | H | C(CH₃)₃ | H | CH₃ | H | 1 | 1 | Co | PMe₃ Cl CO CO | 3 |
| C-45 | H | C(CH₃)₃ | H | CH₃ | H | 1 | 1 | Co | PMe₃ PMe₃ CO | 3 |
| C-46 | H | C(CH₃)₃ | H | CH₃ | H | 1 | 1 | Co | PEt₃ | 2 |
| C-47 | H | C(CH₃)₃ | H | CH₃ | H | 1 | 1 | Co | PEt₃ | 3 |
| C-48 | H | C(CH₃)₃ | H | CH₃ | H | 1 | 1 | Co | depe | 1 |
| C-49 | H | C(CH₃)₃ | H | CH₃ | H | 1 | 1 | Co | depe PMe₃ | 2 |
| C-50 | H | C(CH₃)₃ | H | CH₃ | H | 1 | 1 | Co | depe CO | 2 |
| C-51 | H | C(CH₃)₃ | H | CH₃ | H | 1 | 1 | Co | CO | 2 |
| C-52 | H | C(CH₃)₃ | H | CH₃ | H | 1 | 1 | Co | CO | 3 |
| C-53 | H | C(CH₃)₃ | H | CH₃ | H | 1 | 1 | Co | tmeda | 1 |
| C-54 | H | CH₃ | H | CH₃ | H | 1 | 1 | Co | PMe₃ | 2 |
| C-55 | H | CH₃ | H | CH₃ | CH₃ | 1 | 1 | Co | PMe₃ | 3 |
| C-56 | H | CH₃ | H | CH₃ | CH₃ | 1 | 1 | Co | PF₃ | 2 |
| C-57 | H | CH₃ | H | CH₃ | CH₃ | 1 | 1 | Co | PF₃ | 3 |
| C-58 | H | CH₃ | H | CH₃ | CH₃ | 1 | 1 | Co | PMe₃ CO | 2 |
| C-59 | H | CH₃ | H | CH₃ | CH₃ | 1 | 1 | Co | PMe₃ CO CO | 3 |
| C-60 | H | CH₃ | H | CH₃ | CH₃ | 1 | 1 | Co | PMe₃ PMe₃ CO | 3 |
| C-61 | H | CH₃ | H | CH₃ | CH₃ | 1 | 1 | Co | PEt₃ | 2 |
| C-62 | H | CH₃ | H | CH₃ | CH₃ | 1 | 1 | Co | PEt₃ | 3 |
| C-63 | H | CH₃ | H | CH₃ | CH₃ | 1 | 1 | Co | depe | 1 |
| C-64 | H | CH₃ | H | CH₃ | CH₃ | 1 | 1 | Co | depe PMe₃ | 2 |
| C-65 | H | CH₃ | H | CH₃ | CH₃ | 1 | 1 | Co | depe CO | 2 |
| C-66 | H | CH₃ | H | CH₃ | CH₃ | 1 | 1 | Co | CO | 2 |
| C-67 | H | CH₃ | H | CH₃ | CH₃ | 1 | 1 | Co | CO | 3 |
| C-68 | H | CH₃ | H | CH₃ | CH₃ | 1 | 1 | Co | tmeda | 1 |
| C-69 | H | C(CH₃)₃ | H | CH₃ | H | 1 | 1 | Co | acac | 1 |
| C-70 | H | C(CH₃)₃ | H | C(CH₃)₃ | H | 2 | 2 | Ni | - | 0 |
| C-71 | H | Ph | H | Ph | H | 1 | 2 | Ni | - | 0 |
| C-72 | H | Ph | H | Ph | H | 1 | 2 | Co | - | 0 |
| C-73 | H | Ph | H | Ph | H | 1 | 2 | Ni | - | 0 |
| C-74 | tms | H | H | H | tms | 1 | 2 | Ni | - | 0 |
| C-75 | tms | H | H | H | tms | 1 | 2 | Co | - | 0 |
| C-76 | tms | H | H | H | tms | 1 | 2 | Ni | - | 0 |
| C-77 | H | H | CH₃ | H | H | 1 | 2 | Ni | - | 0 |
| C-78 | H | H | CH₃ | H | H | 1 | 2 | Co | - | 0 |
| C-79 | H | H | CH₃ | H | H | 1 | 2 | Ni | - | 0 |
| C-80 | tms | H | H | H | tms | 1 | 1 | Ni | N(CHMe₂)₂ Cl | 2 |
| C-81 | tms | H | H | H | tms | 1 | 1 | Ni | N(CMe₃)₂ Cl | 2 |
| C-82 | tms | H | H | H | tms | 1 | 1 | Ni | N(C₆H₅)₂ Cl | 2 |
| C-83 | tms | H | H | H | tms | 1 | 1 | Ni | N(SiMe₃)₂ Cl | 2 |
| C-84 | tms | H | H | H | tms | 1 | 1 | Ni | PMe₃ Cl | 2 |
| C-85 | tms | H | H | H | tms | 1 | 1 | Ni | acac | 1 |
| C-86 | tms | H | H | H | tms | 1 | 1 | Co | PMe₃ Cl | 2 |
| C-87 | tms | H | H | H | tms | 1 | 1 | Co | PMe₃ Cl | 3 |
| C-88 | tms | H | H | H | tms | 1 | 1 | Co | PF₃ | 2 |
| C-89 | tms | H | H | H | tms | 1 | 1 | Co | PF₃ | 3 |
| C-90 | tms | H | H | H | tms | 1 | 1 | Co | PMe₃ CO | 2 |
| C-100 | tms | H | H | H | tms | 1 | 1 | Co | PMe₃ CO CO | 3 |
| C-101 | tms | H | H | H | tms | 1 | 1 | Co | PMe₃ PMe₃ CO | 3 |
| C-102 | tms | H | H | H | tms | 1 | 1 | Co | PEt₃ | 2 |
| C-103 | tms | H | H | H | tms | 1 | 1 | Co | PEt₃ | 3 |
| C-104 | tms | H | H | H | tms | 1 | 1 | Co | depe | 1 |
| C-105 | tms | H | H | H | tms | 1 | 1 | Co | depe PMe₃ | 2 |
| C-106 | tms | H | H | H | tms | 1 | 1 | Co | depe CO | 2 |
| C-107 | tms | H | H | H | tms | 1 | 1 | Co | CO | 2 |
| C-108 | tms | H | H | H | tms | 1 | 1 | Co | CO | 3 |
| C-109 | tms | H | H | H | tms | 1 | 1 | Co | tmeda | 1 |
| C-110 | H | H | CH₃ | H | H | 1 | 1 | Ni | N(CHMe₂)₂ Cl | 2 |
| C-111 | H | H | CH₃ | H | H | 1 | 1 | Ni | N(CMe₃)₂ Cl | 2 |
| C-112 | H | H | CH₃ | H | H | 1 | 1 | Ni | N(C₆H₅)₂ Cl | 2 |
| C-113 | H | H | CH₃ | H | H | 1 | 1 | Ni | N(SiMe₃)₂ Cl | 2 |
| C-114 | H | H | CH₃ | H | H | 1 | 1 | Ni | PMe₃ Cl | 2 |
| C-115 | H | H | CH₃ | H | H | 1 | 1 | Ni | acac | 1 |
| C-116 | H | H | CH₃ | H | H | 1 | 1 | Co | PMe₃ | 2 |
| C-117 | H | H | CH₃ | H | H | 1 | 1 | Co | PMe₃ | 3 |
| C-118 | H | H | CH₃ | H | H | 1 | 1 | Co | PF₃ | 2 |
| C-119 | H | H | CH₃ | H | H | 1 | 1 | Co | PF₃ | 3 |
| C-120 | H | H | CH₃ | H | H | 1 | 1 | Co | PMe₃ CO | 2 |
| C-121 | H | H | CH₃ | H | H | 1 | 1 | Co | PMe₃ CO CO | 3 |
| C-122 | H | H | CH₃ | H | H | 1 | 1 | Co | PMe₃ PMe₃ CO | 3 |
| C-123 | H | H | CH₃ | H | H | 1 | 1 | Co | PEt₃ | 2 |
| C-124 | H | H | CH₃ | H | H | 1 | 1 | Co | PEt₃ | 3 |
| C-125 | H | H | CH₃ | H | H | 1 | 1 | Co | depe | 1 |
| C-126 | H | H | CH₃ | H | H | 1 | 1 | Co | depe PMe₃ | 2 |
| C-127 | H | H | CH₃ | H | H | 1 | 1 | Co | depe CO | 2 |
| C-128 | H | H | CH₃ | H | H | 1 | 1 | Co | CO | 2 |
| C-130 | H | H | CH₃ | H | H | 1 | 1 | Co | CO | 3 |
| C-131 | H | H | CH₃ | H | H | 1 | 1 | Co | tmeda | 1 |

PMe₃ Cl stands for trimethylphosphane, P^{t}Bu₃ for tri-(tert-butyl)phosphine, PEt₃ for tri-ethylphosphane, depe for 1,2-bis(diethylphosphino)ethane, N(C₆H₅)₂ Cl for diphenylamine, tmeda for N,N,N',N'-tetramethylethylenediamine, acac for acetylacetonate, and tms for trimethylsilyl.

The compound of general formula (I) used in the process according to the present invention is preferably used at high purity to achieve best results. High purity means that the substance employed contains at least 90 wt.-% compound of general formula (I), preferably at least 95 wt.-% compound of general formula (I), more preferably at least 98 wt.-% compound of general formula (I), in particular at least 99 wt.-% compound of general formula (I). The purity can be determined by elemental analysis according to DIN 51721 (Prüfung fester Brennstoffe - Bestimmung des Gehaltes an Kohlenstoff und Wasserstoff - Verfahren nach Radmacher-Hoverath, August 2001).

In the process according to the present invention the compound of general formula (I) is brought into the gaseous or aerosol state. This can be achieved by heating the compound of general formula (I) to elevated temperatures. In any case a temperature below the decomposition temperature of the compound of general formula (I) has to be chosen. Preferably, the heating temperature ranges from slightly above room temperature to 300 °C, more preferably from 30 °C to 250 °C, even more preferably from 40 °C to 200 °C, in particular from 50 °C to 150 °C.

Another way of bringing the compound of general formula (I) into the gaseous or aerosol state is direct liquid injection (DLI) as described for example in US 2009 / 0 226 612 A1. In this method the compound of general formula (I) is typically dissolved in a solvent and sprayed in a carrier gas or vacuum. Depending on the vapor pressure of the compound of general formula (I), the temperature and the pressure the compound of general formula (I) is either brought into the gaseous state or into the aerosol state. Various solvents can be used provided that the compound of general formula (I) shows sufficient solubility in that solvent such as at least 1 g/l, preferably at least 10 g/l, more preferably at least 100 g/l. Examples for these solvents are coordinating solvents such as tetrahydrofuran, dioxane, diethoxyethane, pyridine or non-coordinating solvents such as hexane, heptane, benzene, toluene, or xylene. Solvent mixtures are also suitable. The aerosol comprising the compound of general formula (I) should contain very fine liquid droplets or solid particles. Preferably, the liquid droplets or solid particles have a weight average diameter of not more than 500 nm, more preferably not more than 100 nm. The weight average diameter of liquid droplets or solid particles can be determined by dynamic light scattering as described in ISO 22412:2008. It is also possible that a part of the compound of general formula (I) is in the gaseous state and the rest is in the aerosol state, for example due to a limited vapor pressure of the compound of general formula (I) leading to partial evaporation of the compound of general formula (I) in the aerosol state.

Alternatively, the metal-containing compound can be brought into the gaseous state by direct liquid evaporation (DLE) as described for example by J. Yang et al. (Journal of Materials Chemistry C, volume 3 (2015) page 12098-12106). In this method, the metal-containing compound or the reducing agent is mixed with a solvent, for example a hydrocarbon such as tetradecane, and heated below the boiling point of the solvent. By evaporation of the solvent, the metal-containing compound or the reducing agent is brought into the gaseous state. This method has the advantage that no particulate contaminants are formed on the surface.

It is preferred to bring the compound of general formula (I) into the gaseous or aerosol state at decreased pressure. In this way, the process can usually be performed at lower heating temperatures leading to decreased decomposition of the compound of general formula (I).

It is also possible to use increased pressure to push the compound of general formula (I) in the gaseous or aerosol state towards the solid substrate. Often, an inert gas, such as nitrogen or argon, is used as carrier gas for this purpose. Preferably, the pressure is 10 bar to 10⁻⁷ mbar, more preferably 1 bar to 10⁻³ mbar, in particular 10 to 0.1 mbar, such as 1 mbar.

In the process according to the present invention a compound of general formula (I) is deposited on a solid substrate from the gaseous or aerosol state. The solid substrate can be any solid material. These include for example metals, semimetals, oxides, nitrides, and polymers. It is also possible that the substrate is a mixture of different materials. Examples for metals are tantalum, tungsten, cobalt, nickel, platinum, ruthenium, palladium, manganese, aluminum, steel, zinc, and copper. Examples for semimetals are silicon, germanium, and gallium arsenide. Examples for oxides are silicon dioxide, titanium dioxide, zirconium oxide, and zinc oxide. Examples for nitrides are silicon nitride, aluminum nitride, titanium nitride, tantalum nitride and gallium nitride. Examples for polymers are polyethylene terephthalate (PET), polyethylene naphthalenedicarboxylic acid (PEN), and polyamides.

The solid substrate can have any shape. These include sheet plates, films, fibers, particles of various sizes, and substrates with trenches or other indentations. The solid substrate can be of any size. If the solid substrate has a particle shape, the size of particles can range from below 100 nm to several centimeters, preferably from 1 µm to 1 mm. In order to avoid particles or fibers to stick to each other while the compound of general formula (I) is deposited onto them, it is preferably to keep them in motion. This can, for example, be achieved by stirring, by rotating drums, or by fluidized bed techniques.

The deposition takes place if the substrate comes in contact with the compound of general formula (I). Generally, the deposition process can be conducted in two different ways: either the substrate is heated above or below the decomposition temperature of the compound of general formula (I). If the substrate is heated above the decomposition temperature of the compound of general formula (I), the compound of general formula (I) continuously decomposes on the surface of the solid substrate as long as more compound of general formula (I) in the gaseous or aerosol state reaches the surface of the solid substrate. This process is typically called chemical vapor deposition (CVD). Usually, an inorganic layer of homogeneous composition, e.g. the metal oxide or nitride, is formed on the solid substrate as the organic material is desorbed from the metal M. Typically the solid substrate is heated to a temperature in the range of 300 to 1000 °C, preferably in the range of 350 to 600 °C.

Alternatively, the substrate is below the decomposition temperature of the compound of general formula (I). Typically, the solid substrate is at a temperature equal to or lower than the temperature of the place where the compound of general formula (I) is brought into the gaseous or aerosol state, often at room temperature or only slightly above. Preferably, the temperature of the substrate is at least 30 °C lower than the place where the compound of general formula (I) is brought into the gaseous or aerosol state. Preferably, the temperature of the substrate is from room temperature to 400 °C, more preferably from 100 to 300 °C, such as 150 to 220 °C.

The deposition of compound of general formula (I) onto the solid substrate is either a physisorption or a chemisorption process. Preferably, the compound of general formula (I) is chemisorbed on the solid substrate. One can determine if the compound of general formula (I) chemisorbs to the solid substrate by exposing a quartz microbalance with a quartz crystal having the surface of the substrate in question to the compound of general formula (I) in the gaseous or aerosol state. The mass increase is recorded by the eigenfrequency of the quartz crystal. Upon evacuation of the chamber in which the quartz crystal is placed the mass should not decrease to the initial mass, but about a monolayer of the residual compound of general formula (I) remains if chemisorption has taken place. In most cases where chemisorption of the compound of general formula (I) to the solid substrate occurs, the X-ray photoelectron spectroscopy (XPS) signal (ISO 13424 EN - Surface chemical analysis - X-ray photoelectron spectroscopy - Reporting of results of thin-film analysis; October 2013) of M changes due to the bond formation to the substrate.

If the temperature of the substrate in the process according to the present invention is kept below the decomposition temperature of the compound of general formula (I), typically a monolayer is deposited on the solid substrate. Once a molecule of general formula (I) is deposited on the solid substrate further deposition on top of it usually becomes less likely. Thus, the deposition of the compound of general formula (I) on the solid substrate preferably represents a self-limiting process step. The typical layer thickness of a self-limiting deposition processes step is from 0.01 to 1 nm, preferably from 0.02 to 0.5 nm, more preferably from 0.03 to 0.4 nm, in particular from 0.05 to 0.2 nm. The layer thickness is typically measured by ellipsometry as described in PAS 1022 DE (Referenzverfahren zur Bestimmung von optischen und dielektrischen Materialeigenschaften sowie der Schichtdicke dünner Schichten mittels Ellipsometrie; February 2004).

Often it is desired to build up thicker layers than those just described. In order to achieve this in the process according to the present invention it is preferable to decompose the deposited compound of general formula (I) by removal of all ligands after which further compound of general formula (I) is deposited. This sequence is preferably performed at least twice, more preferably at least 10 times, in particular at least 50 times. Normally, the sequence is performed not more than 1000 times. Removing all ligands in the context of the present invention means that at least 95 wt.-% of the total weight of the ligands in the deposited compound of general formula (I) are removed, preferably at least 98 wt.-%, in particular at least 99 wt.-%. The decomposition can be effected in various ways. The temperature of the solid substrate can be increased above the decomposition temperature.

Furthermore, it is possible to expose the deposited compound of general formula (I) to a plasma like an oxygen plasma or a hydrogen plasma; to oxidants like oxygen, oxygen radicals, ozone, nitrous oxide (N₂O), nitric oxide (NO), nitrogendioxde (NO₂) or hydrogenperoxide; to reducing agents like hydrogen, alcohols, hydroazine or hydroxylamine; or solvents like water. It is preferable to use oxidants, plasma or water to obtain a layer of a metal oxide. Exposure to water, an oxygen plasma or ozone is preferred. Exposure to water is particularly preferred. If layers of elemental metal are desired it is preferable to use reducing agents. Preferred examples are hydrogen, hydrogen radicals, hydrogen plasma, ammonia, ammonia radicals, ammonia plasma, hydrazine, N,N-dimethylhydrazine, silane, disilane, trisilane, cyclopentasilane, cyclohexasilane, dimethylsilane, diethylsilane, or trisilylamine; more preferably hydrogen, hydrogen radicals, hydrogen plasma, ammonia, ammonia radicals, ammonia plasma, hydrazine, N,N-dimethylhydrazine, silane; in particular hydrogen. The reducing agent can either directly cause the decomposition of the deposited compound of general formula (I) or it can be applied after the decomposition of the deposited compound of general formula (I) by a different agent, for example water. For layers of metal nitrides it is preferable to use ammonia or hydrazine. Typically, a low decomposition time and high purity of the generated film is observed.

A deposition process comprising a self-limiting process step and a subsequent self-limiting reaction is often referred to as atomic layer deposition (ALD). Equivalent expressions are molecular layer deposition (MLD) or atomic layer epitaxy (ALE). Hence, the process according to the present invention is preferably an ALD process. The ALD process is described in detail by George (Chemical Reviews 110 (2010), 111-131).

A particular advantage of the process according to the present invention is that the compound of general formula (I) is very versatile, so the process parameters can be varied in a broad range. Therefore, the process according to the present invention includes both a CVD process as well as an ALD process.

Depending on the number of sequences of the process according to the present invention performed as ALD process, films of various thicknesses are generated. Preferably, the sequence of depositing the compound of general formula (I) onto a solid substrate and decomposing the deposited compound of general formula (I) is performed at least twice. This sequence can be repeated many times, for example 10 to 500, such as 50 or 100 times. Usually, this sequence is not repeated more often than 1000 times. Ideally, the thickness of the film is proportional to the number of sequences performed. However, in practice some deviations from proportionality are observed for the first 30 to 50 sequences. It is assumed that irregularities of the surface structure of the solid substrate cause this non-proportionality.

One sequence of the process according to the present invention can take from milliseconds to several minutes, preferably from 0.1 second to 1 minute, in particular from 1 to 10 seconds. The longer the solid substrate at a temperature below the decomposition temperature of the compound of general formula (I) is exposed to the compound of general formula (I) the more regular films formed with less defects.

The present invention also relates to a compound of general formula (I), wherein at least one X coordinates M via a phosphor atom and contains two or more phosphor atoms. These compounds exhibit an increased stability upon heating and are thus particularly suitable for the process according to the present invention. The same definitions and preferred embodiments as described for the process apply.

In some cases when a Co(II) source is reacted with at least two equivalents of the anionic ligand L, two ligands L are oxidatively coupled to form dimeric complexes of general formula (II), typically containing Co(I) as copper usually gets reduced in this coupling reaction. 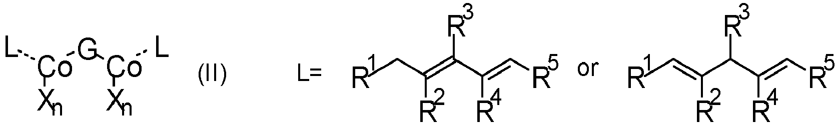 G= 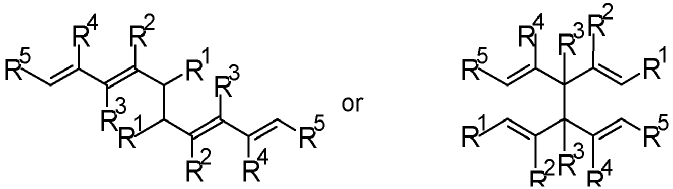 X, n, R¹, R², R³, R⁴, and R⁵ have the same meaning as for the compound of general formula (I). G is a neutral, covalently bound dimer of ligand L. As the compound of general formula (II) is a good starting point for the synthesis of the compound of general formula (I) in which M is Co, the present invention also relates to the compound of general formula (II). Some examples for compounds of general formula (II) are given in the following table.

| No. | R¹ | R2 | R3 | R4 | R5 | X | n |
|---|---|---|---|---|---|---|---|
| C-II-1 | H | CH₃ | H | CH₃ | H | - | 0 |
| C-II-2 | H | C(CH₃)₃ | H | C(CH₃)₃ | H | - | 0 |
| C-II-3 | H | CH₃ | H | C(CH₃)₃ | H | - | 0 |
| C-II-4 | H | CH₃ | H | CH₃ | CH₃ | - | 0 |

The process according to the present invention yields a film. A film can be only one monolayer of deposited compound of formula (I), several consecutively deposited and decomposed layers of the compound of general formula (I), or several different layers wherein at least one layer in the film was generated by using the compound of general formula (I). A film can contain defects like holes. These defects, however, generally constitute less than half of the surface area covered by the film. The film is preferably an inorganic film. In order to generate an inorganic film, all organic ligands have to be removed from the film as described above. More preferably, the film is an elemental metal film. The film can have a thickness of 0.1 nm to 1 µm or above depending on the film formation process as described above. Preferably, the film has a thickness of 0.5 to 50 nm. The film preferably has a very uniform film thickness which means that the film thickness at different places on the substrate varies very little, usually less than 10 %, preferably less than 5 %. Furthermore, the film is preferably a conformal film on the surface of the substrate. Suitable methods to determine the film thickness and uniformity are XPS or ellipsometry.

The film obtained by the process according to the present invention can be used in an electronic element. Electronic elements can have structural features of various sizes, for example from 10 nm to 100 µm, such as 100 nm or 1 µm. The process for forming the films for the electronic elements is particularly well suited for very fine structures. Therefore, electronic elements with sizes below 1 µm are preferred. Examples for electronic elements are field-effect transistors (FET), solar cells, light emitting diodes, sensors, or capacitors. In optical devices such as light emitting diodes or light sensors the film according to the present invention serves to increase the reflective index of the layer which reflects light. An example for a sensor is an oxygen sensor, in which the film can serve as oxygen conductor, for example if a metal oxide film is prepared. In field-effect transistors out of metal oxide semiconductor (MOS-FET) the film can act as dielectric layer or as diffusion barrier. It is also possible to make semiconductor layers out of the films in which elemental nickel-silicon is deposited on a solid substrate.

Preferred electronic elements are transistors. Preferably, the film acts as diffusion barrier, contact, liner or capping layer in a transistor. Diffusion barriers of manganese or cobalt are particularly useful to avoid diffusion of copper contacts into the dielectric, often applied as self-forming copper barrier. If the transistor is made of silicon, it is possible that after deposition of nickel or cobalt and heating some silicon diffuses into the nickel to form for example NiSi or CoSi₂.

### Brief Description of the Figures

Figure 1 shows the thermogravimetric analysis of compound C-2.
Figure 2 shows the crystal structure of compound C-2.
Figure 3 shows crystal structure of compound C-4.
Figure 4 shows the crystal structure of compound C-12.
Figure 5 shows the thermogravimetric analysis of compound C-13.
Figure 6 shows the crystal structure of compound C-13.

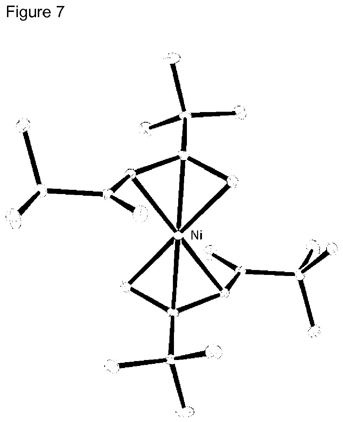

Figure 7 shows the crystal structure of compound C-1.

### Examples

### General Procedures

All experiments were carried out under an atmosphere of purified nitrogen, either in a Schlenk apparatus or in a glovebox. The solvents were dried and deoxygenated by distillation under nitrogen atmosphere from sodium benzophenone ketyl (tetrahydrofuran) and by an MBraun GmbH solvent purification system (toluene, pentane, hexane).

Thermogravimetric analysis was performed with about 20 mg sample. It was heated by a rate of 5 °C/min in an argon stream. For the differential scanning calorimetry measurement (DSC) a 20 mg sample was placed in a glass or steal crucible and put in a Mettler TA 8000. The temperature was increase from 30 to 500 °C at a rate of 2.5 K/min.

Nuclear magnetic resonance (NMR) spectra were recorded on a Bruker DRX 400 spectrometer at 400 MHz (¹H) or 101 MHz (¹³C) and a Bruker Avance II 300 at 300 MHz (¹H) or 75 MHz (¹³C). All chemical shifts are given in δ units with reference to the residual protons of the deuterated solvents, which are internal standards, for proton and carbon chemical shifts. The abbreviations in the hydrogen nuclear magnetic resonance (¹H-NMR) spectra have the conventional meaning: s for singlet, d for doublet, t for triplet, m for multiplet, br for broad.

Single crystals of each compound were examined under Paratone oil. Data were recorded at 100 K on Oxford Diffraction diffractometers using monochromated Mo Kα or mirror-focused Cu Kα radiation. The structures were refined anisotropically using the SHELXL-97 program as described in Acta Crystallographica Section A, volume 64 (2008) pages 112-122. Elemental analyses were performed on a vario MICRO cube elemental analyzer. Electron impact mass spectrometry (EI-MS) was carried out on Finnigan MAT 90 X (EI).

### Ligand synthesis

### Potassium 2,4-di-tertbutylpentadienide L¹

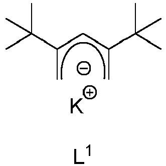

The synthesis is based on the method reported in Dalton Trans. volume 43 (2014) page 6614.

A Schlenk flask was charged with small pieces of potassium (542 mg, 13.9 mmol, 0.5 eq.), THF (10 mL) and Et₃N (5 mL). The reaction mixture was cooled to 0 °C before 2,4-di-*tert.*butylpenta-diene (5.00 g, 27.7 mmol, 1.0 eq.) was slowly added. During the addition, the color of the reaction mixture changed from colorless to light yellow and the formation of a yellow precipitate was observed. The suspension was warmed up to 50 °C and stirred for 48 h until all potassium was consumed. The reaction mixture was cooled to room temperature before n-hexane (50 mL) was added. The yellow precipitate was filtered, washed with hexane (3 x 20 mL) and dried in vacuo to obtain L¹ as colorless powder in 44 % yield (1.34 g, 6.1 mmol).

### Potassium 2-methyl-4-tert.butylpentadienide L²

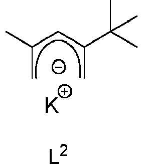

A Schlenk flask was charged with small pieces of potassium (707 mg, 18.1 mmol, 0.5 eq.), THF (10 mL) and Et₃N (5 mL). The reaction mixture was cooled to 0 °C before 2-methyl-4-tert.butylpentadiene (5.00 g, 36.2 mmol, 1.0 eq.) was slowly added. During the addition, the color of the reaction mixture changed from colorless to light yellow and a yellow precipitate formed. The suspension was warmed up to room temperature and stirred for 16 h until all potassium was consumed. The solvent was removed in dynamic vacuum before n-hexane (50 mL) was added to the yellow, oily residue. Upon stirring the reaction mixture over night a colorless precipitate formed that was filtered, washed with hexane (3 x 20 mL) and dried in vacuo to obtain L² as a colorless solid in 67 % yield (3,0 g, 12.1 mmol).

### Synthesis of metal complexes

### Example 1

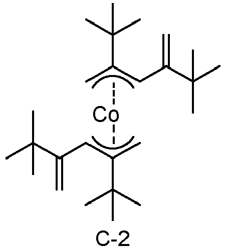

To a stirred solution of Co(acac)₂ (235 mg, 0.92 mmol, 0.5 eq.) in 10 mL of THF a suspension of L¹ (400 mg, 1.83 mmol, 1.0 eq.) in 10 ml of THF was slowly added at -78 °C. A brownish precipitate formed immediately and the color of the solution changed from violet to red-brown. The reaction mixture was warmed to room temperature and stirred for 2 h. The solvent was removed in dynamic vacuum and the residue was extracted with pentane (20 mL). The red extracts were filtered and dried to obtain a red-brown solid, which was dissolved in a small amount of pentane (ca. 1 mL) and cooled to -30 °C for crystallization. The next day C-2 was isolated in 76 % yield (290 mg, 0.17 mmol) as red microcrystalline solid. C-2 can be further purified by sublimation/distillation at 10⁻³ mbar and 40 °C CHN calculated (%) for C₂₆H₄₆Co: C 74.78, H 11.10, found: C 74.47, H 10.926 EI-MS: M⁺ 417.3 amu. M.p.: >50 °C (dec.)

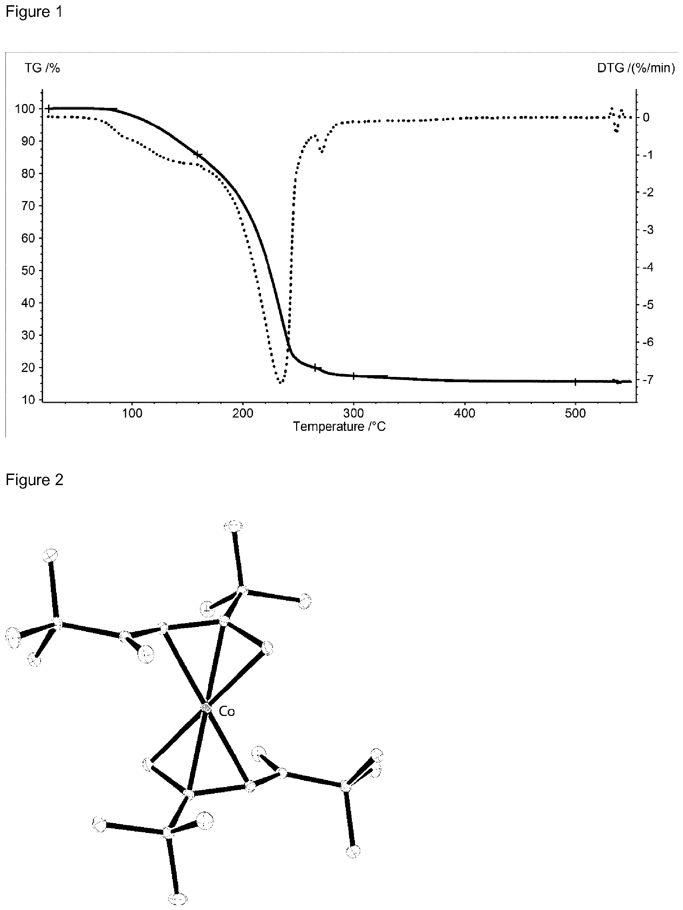

The thermogravimetric analysis of C-2 is depicted in figure 1. Deriving from the thermogravimetric analysis, the sample has lost 84.5 % of its mass at 500 °C.

Crystals of C-2 suitable for X-ray diffraction were obtained from a pentane solution at -30 °C. The crystal structure is shown in figure 2.

### Example 2

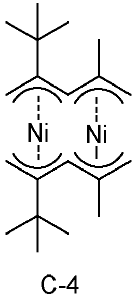

To a stirred solution of Ni(acac)₂ (103 mg, 0.403 mmol, 0.5 eq.) in 5 mL of THF a suspension of L² (200 mg, 0.805 mmol, 1.0 eq.) in 5 ml of THF was added slowly at room temperature. Immediately, the color of the reaction mixture changed from green to red. After stirring for 1 h the solution was evaporated to dryness and the residue was extracted with n-hexane (20 mL). The red extracts were filtered and evaporated to obtain a red residue, which dissolved in a small amount of Et₂O (ca. 0.5 mL). The solution was kept at -30 °C to give C-4 as red crystals in 27% yield (42.6 mg, 0.109 mmol).

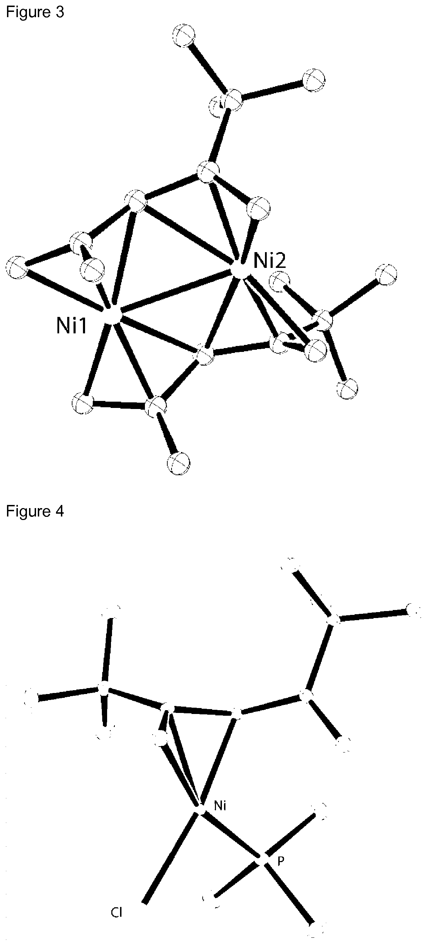

Crystals of C-4 suitable for X-ray diffraction were obtained from a Et₂O solution at -30 °C. The crystal structure is shown in figure 3.

### Example 3

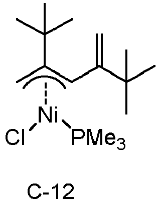

To a stirred solution of NiCl₂(PMe₃)₂ (258 mg, 0,92 mmol, 1.0 eq.) in THF (10 mL) a suspension of L¹ (200 mg, 0,92 mmol, 1.0 eq.) in THF (10 mL) was added slowly. The color of the reaction mixture immediately changed from dark red to slight red. The reaction mixture was stirred at room temperature for 1h. The solvent was removed in dynamic vacuum and the residue was extracted with hexane (40 mL). After removing the solvent the orange red residue was dissolved in a minimum amount of pentane (ca. 1 mL) filtered and cooled to -30 °C. After one day orange red crystals of C-12 were obtained.

Crystals of C-12 suitable for X-ray diffraction were obtained from a pentane solution at -30 °C. The crystal structure is shown in figure 4.

### Example 4

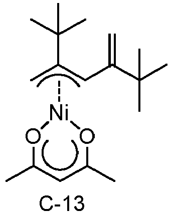

To a stirred solution of Ni(acac)₂ (470 mg, 1.83 mmol, 1.0 eq.) in 10 mL of THF a suspension of L¹ (400 mg, 1.83 mmol, 1.0 eq.) in 10 mL of THF was added slowly at room temperature. Immediately, the color of the reaction mixture changed from green to dark red. After stirring for 2 h solution was evaporated to dryness and the residue was extracted with n-hexane (40 mL). The red extracts were filtered and evaporated to obtain a red residue, which dissolved in a small amount of Et₂O (0.5 mL). The solution was kept at -30 °C to give C-13 as yellow needles in 35% yield (216 mg, 0.64 mmol).

¹H NMR (C₆D₆, 298 K): δ = 5.19 (1H CH s), 5.09 (1H CH s), 4.89 (1H CH s), 4.36 (1H CH₂ s), 3.04 (1H CH s), 2.47 (1H CH s), 1.76 (3H CH₃ s), 1.74 (3H CH₃ s), 1.45 (9H CH₃ s) ppm. ¹³C{¹H} NMR (C₆D₆, 298 K): δ = 187.6 (C), 186.9 (C), 158.8 (C), 108.4 (CH₂), 100.0 (CH), 63.3 (CH), 49.4 (CH₂), 36.2 (C), 35.6 (C), 30.7 (CH₃), 30.3 (CH₃), 27.4 (CH₃), 27.2 (CH₃) ppm. EI-MS: M⁺ 337.1 amu.

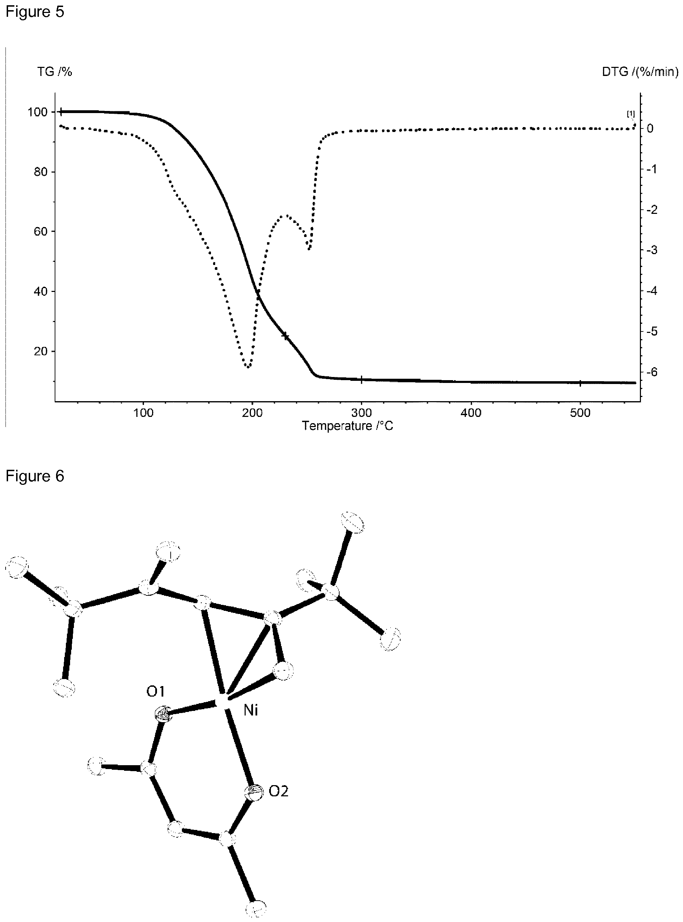

The thermogravimetric analysis of C-13 is depicted in figure 5. Deriving from the thermogravimetric analysis, the sample has lost 90.4 % of its mass at 500 °C.

Crystals of C-13 suitable for X-ray diffraction were obtained from Et₂O solution at -30 °C. The crystal structure is shown in figure 6.

### Example 5

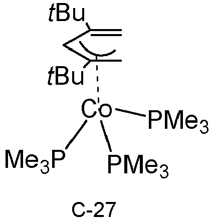

To a stirred solution of [CoCl(PMe₃)₃] (148 mg, 0.458 mmol, 1.0 eq.) in THF (10 mL) a suspension of L¹ (100 mg, 0.458 mmol, 1.0 eq.) in THF (10 mL) was added slowly. The color of the solution changed immediately from dark blue to red-brown. The reaction mixture was stirred at ambient temperature for 24 h. The solvent was removed in dynamic vacuum and the red-brown residue was extracted with hexane (4 × 5 mL). After removing the solvent in dynamic vacuum a red-brown highly viscous oil was isolated.

³¹P{¹H} NMR (C₆D₆, 298 K): *δ* = 21.51, -16.78 ppm.
m.p.: < 20 °C

LIFDI-MS from C₆D₆-Solution: m/z = 466, calc for M⁺ = [C₂₂H₅₀CoP₃]⁺ = 466.246; m/z = 390 , calc for [M - PMe₃]⁺ = [C₁₉H₄₁CoP₂] = 390.202.

### Example 6

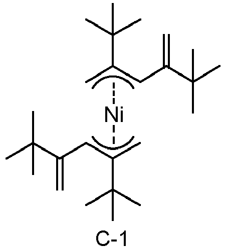

To a stirred solution of Ni(acac)₂ (118 mg, 0.46 mmol, 1.0 eq.) in 10 mL of THF a suspension of L¹ (200 mg, 0.92 mmol, 1.0 eq.) in 10 mL THF was added slowly at -78 °C. Immediately, the color of the reaction mixture changed from green to dark red. After stirring for 1 h solution was evaporated to dryness and the residue was extracted with n-hexane (20 mL). The red extracts were filtered and evaporated to obtain a red residue, which dissolved in a small amount of Et₂O (0.5 mL). The solution was kept at -30 °C to give C-1 as red blocks.

¹H NMR (C₆D₆, 298 K): δ = 4.73 (2H CH s), 4.02 (8H CH₂ br. s), 1.20 (36H CH₃ s) ppm.

## Claims

1. A process comprising bringing a compound of general formula (I) into the gaseous or aerosol state 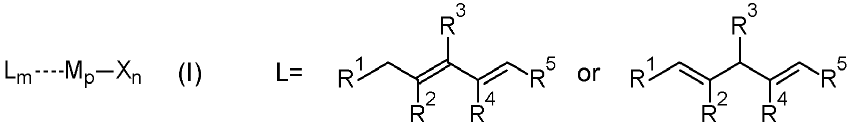
and depositing the compound of general formula (I) from the gaseous or aerosol state onto a solid substrate, wherein
R¹, R², R³, R⁴, and R⁵ are independent of each other hydrogen, an alkyl group, an alkenyl group, an aryl group or a silyl group,
p is 1 or 2,
M is Ni or Co,
X is a σ-donating ligand which coordinates M,
m is 1 or 2 and
n is 0 to 3.

2. The process according to claim 1, wherein M is in the oxidation state +1 or +2.

3. The process according to claim 2, wherein M is Co, m is 1, and all X are neutral σ-donating ligands.

4. The process according to claim 2, wherein M is Ni, m is 1, and one X is anionic and the remaining X, if any, are neutral.

5. The process according to claim 2, wherein M is Ni, m is 2, and n is 0.

6. The process according to any of the claims 1 to 4, wherein at least one X is CO or a ligand which coordinates M via a phosphor or nitrogen atom.

7. The process according to any of the claims 1 to 6, wherein R is independent of each other hydrogen, methyl, ethyl, iso-propyl.

8. The process according to any of the claims 1 to 7, wherein the deposited compound of general formula (I) is exposed to a reducing agent.

9. The process according any of the claims 1 to 8, wherein a sequence of depositing the compound of general formula (I) onto a solid substrate and decomposing the deposited compound of general formula (I) is performed at least twice.

10. A compound of general formula (I), wherein
R¹, R², R³, R⁴, and R⁵ is independent of each other hydrogen, an alkyl group, an alkenyl group, an aryl group or a silyl group,
p is 1 or 2,
M is Ni or Co,
X is a σ-donating ligand which coordinates M, wherein at least one X coordinates M via a phosphor atom and contains two or more phosphor atoms,
m is 1 or 2 and
n is 1 to 3.

11. The compound of general formula (I) according to claim 10, wherein M is Co, m is 1, and all X are neutral σ-donating ligands.

12. The compound of general formula (I) according to claim 10, wherein M is Ni, m is 2, and n is 1 to 3.

13. The compound of general formula (I) according to claim 10, wherein R², and R⁴ are independent of each other methyl, ethyl, iso-propyl, or tert-butyl and R¹, R³, and R⁵ are hydrogen.

14. Use of a compound of general formula (I) according to any of the claims 10 to 13 for a film formation process.

## Patentansprüche

1. Verfahren, bei dem man eine Verbindung der allgemeinen Formel (I) in den gasförmigen Zustand oder Aerosol-Zustand bringt, 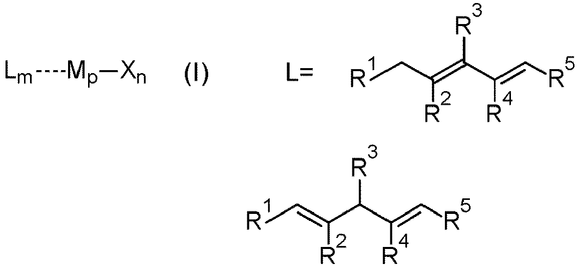 oder
und die Verbindung der allgemeinen Formel (I) aus dem gasförmigen Zustand oder Aerosol-Zustand auf einem festen Substrat abscheidet, wobei R¹, R², R³, R⁴ und R⁵ unabhängig voneinander für Wasserstoff, eine Alkylgruppe, eine Alkenylgruppe, eine Arylgruppe oder eine Silylgruppe stehen,
p für 1 oder 2 steht,
M für Ni oder Co steht,
X für einen σ-Donorliganden steht, der M koordiniert,
m für 1 oder 2 steht und
n für 0 bis 3 steht.

2. Verfahren nach Anspruch 1, bei dem M in der Oxidationsstufe +1 oder +2 vorliegt.

3. Verfahren nach Anspruch 2, bei dem M für Co steht, m für 1 steht und alle X für neutrale σ-Donorliganden stehen.

4. Verfahren nach Anspruch 2, bei dem M für Ni steht, m für 1 steht und ein X anionisch ist und die übrigen X, sofern vorhanden, neutral sind.

5. Verfahren nach Anspruch 2, bei dem M für Ni steht, m für 2 steht und n für 0 steht.

6. Verfahren nach einem der Ansprüche 1 bis 4, bei dem mindestens ein X für CO oder einen Liganden steht, der M über ein Phosphor- oder Stickstoffatom koordiniert.

7. Verfahren nach einem der Ansprüche 1 bis 6, bei dem R unabhängig voneinander für Wasserstoff, Methyl oder Isopropyl steht.

8. Verfahren nach einem der Ansprüche 1 bis 7, bei dem die abgeschiedene Verbindung der allgemeinen Formel (I) einem Reduktionsmittel ausgesetzt wird.

9. Verfahren nach einem der Ansprüche 1 bis 8, bei dem die Sequenz der Abscheidung der Verbindung der allgemeinen Formel (I) auf einem festen Substrat und der Zersetzung der abgeschiedenen Verbindung der allgemeinen Formel (I) mindestens zweimal durchgeführt wird.

10. Verbindung der allgemeinen Formel (I), wobei R¹, R², R³, R⁴ und R⁵ unabhängig voneinander für Wasserstoff, eine Alkylgruppe, eine Alkenylgruppe, eine Arylgruppe oder eine Silylgruppe stehen,
p für 1 oder 2 steht,
M für Ni oder Co steht,
X für einen σ-Donorliganden steht, der M koordiniert, wobei mindestens ein X M über ein Phosphoratom koordiniert und zwei oder mehr Phosphoratome enthält,
m für 1 oder 2 steht und
n für 1 bis 3 steht.

11. Verbindung der allgemeinen Formel (I) nach Anspruch 10, wobei M für Co steht, m für 1 steht und alle X für neutrale σ-Donorliganden stehen.

12. Verbindung der allgemeinen Formel (I) nach Anspruch 10, wobei M für Ni steht, m für 2 steht und n für 1 bis 3 steht.

13. Verbindung der allgemeinen Formel (I) nach Anspruch 10, wobei R² und R⁴ unabhängig voneinander für Methyl, Ethyl, Isopropyl oder tert.-Butyl stehen und R¹, R³ und R⁵ für Wasserstoff stehen.

14. Verwendung einer Verbindung der allgemeinen Formel (I) nach einem der Ansprüche 10 bis 13 für ein Filmbildungsverfahren.

## Revendications

1. Procédé comprenant le fait d'amener un composé de formule générale (I) à l'état gazeux ou d'aérosol 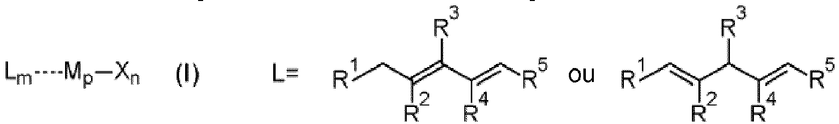
et le dépôt du composé de formule générale (I) de l'état gazeux ou d'aérosol sur un substrat solide, R¹, R², R³, R⁴ et R⁵ étant indépendamment les uns des autres hydrogène, un groupe alkyle, un groupe alcényle, un groupe aryle ou un groupe silyle,
p étant 1 ou 2,
M étant Ni ou Co,
X étant un ligand σ-donneur qui coordonne M,
m étant 1 ou 2 et
n étant 0 à 3.

2. Procédé selon la revendication 1, M étant dans l'état d'oxydation +1 ou +2.

3. Procédé selon la revendication 2, M étant Co, m étant 1, et tous les X étant des ligands σ-donneurs neutres.

4. Procédé selon la revendication 2, M étant Ni, m étant 1, et un X étant anionique et le X restant, le cas échéant, étant neutre.

5. Procédé selon la revendication 2, M étant Ni, m étant 2, et n étant 0.

6. Procédé selon l'une quelconque des revendications 1 à 4, au moins un X étant CO ou un ligand qui coordonne M via un atome de phosphore ou d'azote.

7. Procédé selon l'une quelconque des revendications 1 à 6, R étant indépendamment l'un de l'autre hydrogène, méthyle, éthyle, iso-propyle.

8. Procédé selon l'une quelconque des revendications 1 à 7, le composé déposé de formule générale (I) étant exposé à un agent de réduction.

9. Procédé selon l'une quelconque des revendications 1 à 8, une séquence de dépôt du composé de formule générale (I) sur un substrat solide et de décomposition du composé déposé de formule générale (I) étant réalisée au moins deux fois.

10. Composé de formule générale (I)
R¹, R², R³, R⁴ et R⁵ étant indépendamment les uns des autres hydrogène, un groupe alkyle, un groupe alcényle, un groupe aryle ou un groupe silyle,
p étant 1 ou 2,
M étant Ni ou Co,
X étant un ligand σ-donneur qui coordonne M, au moins un X coordonnant à M via un atome de phosphore et contenant deux atomes de phosphore ou plus,
m étant 1 ou 2 et
n étant 1 à 3.

11. Composé de formule générale (I) selon la revendication 10, M étant Co, m étant 1, et tous les X étant des ligands σ-donneurs neutres.

12. Composé de formule générale (I) selon la revendication 10, M étant Ni, m étant 2, et n étant 1 à 3.

13. Composé de formule générale (I) selon la revendication 10, R² et R⁴ étant indépendamment l'un de l'autre méthyle, éthyle, iso-propyle, ou tert-butyle et R¹, R³ et R⁴ étant hydrogène.

14. Utilisation d'un composé de formule générale (I) selon l'une quelconque des revendications 10 à 13 pour un procédé de formation de film.
